# EUROPEAN PATENT APPLICATION

(11) **EP 4 832 667 A1**
(43) Date of publication of application: **28.10.2026**
(21) Application number: 24905324.0
(22) Date of filing: 28.02.2024
(51) Int. Cl.: H05H 1/24, H05H 1/02, H05H 1/00

(54) **PLASMA POWER SUPPLY AND CONTROL METHOD THEREFOR, AND FUSION REACTION SYSTEM**

(30) Priority: 22.12.2023 CN 202311786579
(71) Applicant: Shanghai Startorus Fusion Technology Company Limited, Shanghai 201808 (CN)
(72) Inventor: XIN, Tao, Shanghai 201808 (CN); SONG, Zichong, Shanghai 201808 (CN); ZHOU, Hongran, Shanghai 201808 (CN); WEI, Guolin, Shanghai 201808 (CN); CHEN, Rui, Shanghai 201808 (CN); TAN, Yi, Shanghai 201808 (CN)
(74) Representative: KIPA AB
(86) International application number: PCT/CN2024/079121
(87) International publication number: WO 2025/129818

(57) **Abstract**

A plasma power supply (10) and a control method therefor, and a fusion reaction system. The plasma power supply (10) comprises: a breakdown power supply module (101) and an extraction power supply module (102). The breakdown power supply module (101) is used for: outputting a first voltage to a plasma generator (20) which generates plasma under the application of the first voltage; and when the output voltage is decreased from the first voltage to a second voltage, maintaining the output of the second voltage to the plasma generator (20). The extraction power supply module (102) is used for forming an electric field between the plasma generator (20) and a housing (30) of a nuclear fusion reaction chamber, and when the plasma generator (20) generates the plasma, forming a plasma current between the housing (30) and the plasma generator (20) on the basis of the plasma and the electric field. The plasma power supply (10) allows for direct formation of the plasma current in the nuclear fusion reaction chamber, thereby simplifying the formation process of the plasma current.

## Description

The present application claims priority to Chinese Patent Application No.202311786579.4, filed on December 22, 2023 and entitled "PLASMA POWER SUPPLY AND CONTROL METHOD THEREFOR, AND FUSION REACTION SYSTEM", the entire content of which is incorporated herein by reference.

### FIELD

The present application relates to the technical field of power electronics, and in particular, to a plasma power supply and a method for control the same, and a fusion reaction system.

### BACKGROUND

With the development of electronic technology, there are more and more electronic devices with various functions, and the electronic devices with different functions have different requirements for current.

For example, a plasma gun (that is, a plasma generator) may be used in the nuclear fusion reaction apparatus to input plasma into a nuclear fusion reaction chamber. After that, the plasma in the nuclear fusion reaction chamber may be controlled by the magnetic field to form a plasma current, and the plasma is heated to a fusion reaction temperature for fusion reaction.

However, at present, a process of forming the plasma current in the nuclear fusion reaction chamber based on the plasma outputted by the plasma gun is complex.

### SUMMARY

In view of this, a plasma power supply and a method for controlling the same, and a fusion reaction system are provided according to the present disclosure, which can directly form a plasma current in a nuclear fusion reaction chamber, thereby simplifying a formation process of the plasma current.

In an aspect of the present disclosure, a plasma power supply is provided, which includes: a breakdown power supply module and a lead-out power supply module. The breakdown power supply module is configured to provide a first voltage to a plasma generator, where the plasma generator generates plasma under the action of the first voltage; and maintain a second voltage to be outputted to the plasma generator in a case that an output voltage is decreased from the first voltage to the second voltage. The lead-out power supply module is configured to form an electric field between the plasma generator and a housing of a nuclear fusion reaction chamber, and form a plasma current between the housing and the plasma generator based on the plasma and the electric field in a case that the plasma generator generates the plasma.

In another aspect of the present disclosure, a method for controlling a plasma power supply is provided, which is applied to the above plasma power supply. The method includes:
controlling a breakdown power supply module in the plasma power supply to provide a first voltage to a plasma generator, and maintaining, in a case that an output voltage is decreased from the first voltage to the second voltage, a second voltage to be outputted to the plasma generator; and
controlling a lead-out power supply module in the plasma power supply to form an electric field between the plasma generator and a housing of a nuclear fusion reaction chamber, and to form a plasma current between the housing and the plasma generator based on the plasma and the electric field in a case that the plasma generator generates the plasma.

In another aspect of the present disclosure, a fusion reaction system is provided, which includes: a nuclear fusion reaction apparatus, a plasma generator and the above plasma power supply. In the plasma power supply, the positive electrode of the breakdown power supply module and the negative electrode of the lead-out power supply module are both connected with the cathode of the plasma generator, and the negative electrode of the breakdown power supply module is connected with the cathode of the plasma generator, and the negative electrode of the lead-out power supply module is connected with the housing of the nuclear fusion reaction chamber in the nuclear fusion reaction apparatus.

The plasma power supply provided in the present disclosure includes a breakdown power supply module and a lead-out power supply module, where the breakdown power supply module may be used to drive a plasma generator to generate plasma, and the plasma is maintained at a stage that an output voltage of the breakdown power supply module is maintained at a second voltage. The lead-out power supply module may form an electric field between the plasma generator and a housing of a nuclear fusion reaction chamber, and form a plasma current between the housing and the plasma generator based on the plasma generated by the plasma generator and the electric field, so that the plasma current is led out into the nuclear fusion reaction chamber. Therefore, the plasma current can be obtained without applying an additional magnetic field to control the plasma generated by the plasma generator, thereby simplifying a formation process of the plasma current.

### BRIEF DESCRIPTION OF THE DRAWINGS

FIG. 1 is a schematic structural diagram of a fusion reaction system according to an embodiment of the present disclosure;
FIG. 2 is a schematic structural diagram of a circuit of a plasma power supply according to an embodiment of the present disclosure; and
FIG. 3 is a flow chart of a method for controlling a plasma power supply according to an embodiment of the present disclosure.

### DETAILED DESCRIPTION OF EMBODIMENTS

In the following description, numerous specific details are set forth in order to provide a thorough understanding of the present disclosure. The present disclosure may be implemented in many other ways than those described herein, and those skilled in the art may make similar promotions without violating the meaning of the present disclosure, and therefore the present disclosure is not limited to the specific embodiments below.

Terms used in one or more embodiments of the present disclosure are intended only to describe specific embodiments and are not intended to limit one or more embodiments of the present disclosure. The terms "a", "the" and "this" in the singular form as used in one or more embodiments of the present disclosure and the claims are also intended to include the plural form unless the context clearly indicates otherwise. It should also be understood that the term "and/or" as used in one or more embodiments of the present disclosure refers to and encompasses any or all possible combinations of one or more related listed items. The term "at least one" in one or more embodiments of the present disclosure means "one or more" and "more" means "two or more". The term "include/comprise" is a non-exclusive description and should be understood to mean "including/comprising but not limited" and may include additional content in addition to what has been described.

It should be understood that although the terms "first", "second" and the like may be used to describe various information in one or more embodiments of the present disclosure, such information should not be limited to these terms. These terms are used only to distinguish the same type of information from one another. For example, without departing from the scope of one or more embodiments of the present disclosure, "first" may also be referred to as "second", and similarly, "second" may also be referred to as "first". Depending on the context, the word "if" as used here may be interpreted as "when..." or "in a case that..." or "respond to determination".

Currently, nuclear fusion is widely studied due to its capability to provide a large amount of clean energy using low-cost fuels. In some implementations of the nuclear fusion reaction, a plasma generator (such as a plasma gun) is used for pre-ionization to break down the gas to generate the plasma required by the nuclear fusion reaction, then the plasma is driven by an induced current or a non-induced current to realize the nuclear fusion reaction. The plasma generator breaks down the gas to generate the plasma by a voltage applied by the plasma power supply. In order to ensure the stability and efficiency of the nuclear fusion reaction, the plasma generator is required to generate and maintain the plasma stably.

In the conventional art, a single high voltage capacitor is used in a plasma power supply to apply a voltage to the plasma generator to achieve gas breakdown and plasma maintenance. In this case, the capacitor is required to have the characteristics of high voltage and large capacity, the implementation and control of the capacitor are difficult, and an economy of the plasma power supply is poor. Moreover, the plasma generator can only generate plasma, which is subsequently driven by other components in the nuclear fusion reaction system. In order to ensure that the plasma generator generates the required plasma, the plasma generator needs to be tested by leading out the plasma current before actual use. The plasma power supply connected with the plasma generator in the conventional art cannot directly lead out this current, so a test process of the plasma generator is complicated.

A plasma power supply is provided according to an embodiment of the present disclosure, which has low difficulties in implementation and controlling and has relatively high economy. The plasma current can be led out for the plasma generator, facilitating the test of the plasma generator. The plasma current can be directly formed in a nuclear fusion reaction chamber while using the plasma generator, so that a forming process of the plasma current is simplified. The embodiment of the present disclosure further relates to a method for controlling a plasma power supply and a fusion reaction system.

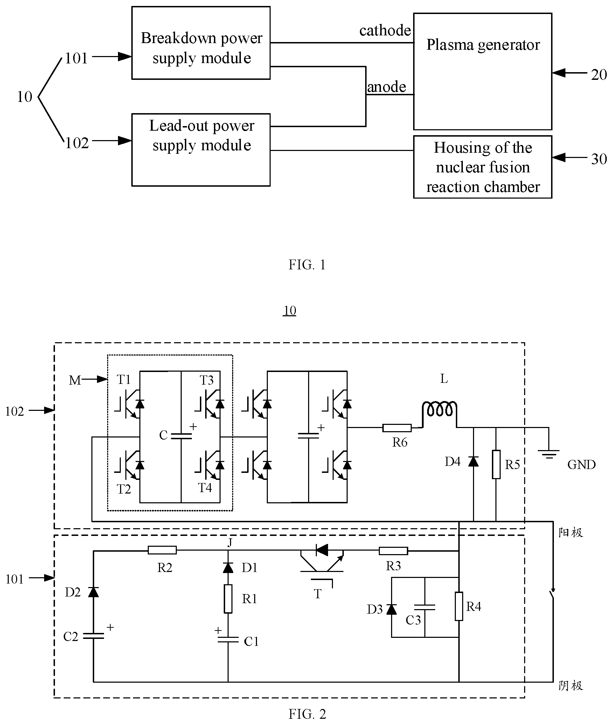

FIG. 1 is a schematic structural diagram of a fusion reaction system according to an embodiment of the present disclosure. The fusion reaction system includes a plasma power supply 10, a plasma generator 20, and a nuclear fusion reaction apparatus (not shown in the drawings).

The nuclear fusion reaction apparatus may include a nuclear fusion reaction chamber, which is configured to accommodate the plasma to generate a nuclear fusion reaction. In a case that the nuclear fusion reaction is carried out, the nuclear fusion reaction chamber is usually required to be kept in a vacuum state, and the nuclear fusion reaction chamber may also be referred to as a vacuum chamber.

A plasma generator 20 may be fixed to the nuclear fusion reaction chamber. If the nuclear fusion reaction chamber is provided with a window, a head of the plasma generator 20 may extend into the window, so that a head space of the plasma generator 20 communicates with an inner space of the nuclear fusion reaction chamber. The plasma generator 20 has an anode and a cathode, and generates plasma by breaking down the gas between the anode and the cathode. The anode and the cathode are provided at the head of the plasma generator 20 to inject the generated plasma into the nuclear fusion reaction chamber. The plasma generator 20 may be a plasma gun.

As shown in FIG. 1, the plasma power supply 10 includes a breakdown power supply module 101 and a lead-out power supply module 102. A positive electrode of the breakdown power supply module 101 may be connected with a negative electrode of the lead-out power supply module 102, and both of the positive electrode of the breakdown power supply module 101 and the negative electrode of the lead-out power supply module 102 are then connected with an anode of the plasma generator 20. A negative electrode of the breakdown power supply module 101 may be connected with a cathode of the plasma generator 20, and a positive electrode of the lead-out power supply module 102 may be connected with a housing 30 of the nuclear fusion reaction chamber. The housing 30 of the nuclear fusion reaction chamber may have an outer electrode that is grounded. The positive electrode of the lead-out power supply module 102 is connected with the housing 30 of the nuclear fusion reaction chamber, so as to be connected with the outer electrode.

The breakdown power supply module 101 is configured to output a first voltage to the plasma generator 20, so that the plasma generator 20 breaks down the gas between the anode and the cathode under an action of the first voltage to generate plasma. After that, a plasma current may be formed between the anode and the cathode, and the breakdown power supply module 101 forms a current loop with the anode and the cathode. In a case that the plasma current is formed between the anode and the cathode, the output voltage of the breakdown power supply module 101 may gradually decrease. In a case that the output voltage decreases to a second voltage, the breakdown power supply module 101 may maintain the second voltage to be outputted to the plasma generator 20.

The lead-out power supply module 102 is configured to form an electric field between the plasma generator 20 and the housing 30 of the nuclear fusion reaction chamber. In a case that the plasma generator 30 generates the plasma, the plasma may diffuse between the plasma generator 20 and the housing 30 of the nuclear fusion reaction chamber, then a plasma current may be formed between the housing 30 of the nuclear fusion reaction chamber and the plasma generator 20 under an action of the electric field. In this way, the plasma current between the anode and the cathode of the plasma generator 30 may be considered to be led out into a space between the housing 30 of the nuclear fusion reaction chamber and the plasma generator 20.

In the embodiment of the present disclosure, in a case that the plasma generator 20 generates the plasma under the action of the voltage outputted by the breakdown power supply module 101, the housing 30 of the nuclear fusion reaction chamber, and the anode and the cathode of the plasma generator 20 may sequentially form a plasma current loop, so that the plasma current is led out into the nuclear fusion reaction chamber. Since the housing 30 of the nuclear fusion reaction chamber is grounded, the anode of the plasma generator 20 may be at a negative potential and the cathode of the plasma generator 20 may be at an even lower potential with respect to the housing 30 of the nuclear fusion reaction chamber.

In the plasma power supply 10 according to the embodiment of the present disclosure, the breakdown power supply module 101 may be a front-stage power supply of the lead-out power supply module 102, and the lead-out power supply module 102 may be a rear-stage power supply of the breakdown power supply module 101. The plasma power supply 10 has the capability of simultaneously driving the plasma generator 20 and two sections of the plasma load in the nuclear fusion reaction chamber. In a fusion reaction system, the plasma current may be directly formed in the nuclear fusion reaction chamber by using the plasma power supply 10 without additionally forming a magnetic field through other structures to drive the plasma, thereby simplifying the formation process of the plasma current in the nuclear fusion reaction chamber.

In the embodiment of the present disclosure, the plasma generator 20 may also be tested in a case that the plasma generator 20 is not provided in the nuclear fusion reaction chamber. For example, the plasma current generated by the plasma generator 20 is led out into a test space by using the plasma power supply 10, to detect whether the plasma current meets the requirement. In this case, the anode of the lead-out power supply module 102 of the plasma power supply 10 may be connected with an electrode in the test space without being connected with the housing 30 of the nuclear fusion reaction chamber. If the plasma current meets the requirement, the plasma generator 20 is applied to the nuclear fusion reaction to ensure a high performance of the plasma generator 20 when applied to the nuclear fusion reaction, so as to ensure that a good effect of nuclear fusion reaction.

The plasma power supply 10 is described below with reference to the drawings. FIG. 2 is a schematic structural diagram of a circuit of a plasma power supply according to an embodiment of the present disclosure. As shown in FIG.2, the plasma power supply 10 includes the breakdown power supply module 101 and the lead-out power supply module 102. The anode and the cathode in FIG. 2 refer to the anode and the cathode of the plasma generator, respectively, and a ground terminal GND in FIG. 2 represents the housing of the nuclear fusion reaction chamber.

The breakdown power supply module 101 may include: a first capacitor C1, a second capacitor C2, and a switching unit T. The first capacitor C1 and the second capacitor C2 are connected in parallel, a positive electrode of the parallel-connected capacitors is connected with the anode of the plasma generator through a switching unit T, and a negative electrode of the parallel-connected capacitors is connected with the cathode of the plasma generator. As shown in FIG. 2, a positive electrode of the first capacitor C1 is connected with a positive electrode of the second capacitor C2, a negative electrode of the first capacitor C1 is connected with a negative electrode of the second capacitor C2, the positive electrode of the first capacitor C1 is further connected with a first end of the switching unit T, a second end of the switching unit T is connected with an anode of the plasma generator, and the negative electrode of the first capacitor C1 is further connected with a cathode of the plasma generator.

A capacitance of the first capacitor C1 may be less than a capacitance of the second capacitor C2, and an output voltage of the first capacitor C1 may be greater than an output voltage of the second capacitor C2. For example, the output voltage of the first capacitor C1 is a first voltage, and the output voltage of the second capacitor C2 is a second voltage. The first capacitor C1 is a high-voltage low-capacitance capacitor, and the second capacitor C2 is a low-voltage high-capacitance capacitor. For example, the first capacitor C1 may be a high-voltage thin film capacitor, and the second capacitor C2 may be an aluminum electrolytic capacitor. Each of the first capacitor C1 and the second capacitor C2 may be a single capacitor or a capacitor group formed by connecting multiple capacitors in parallel.

In a case that the switching unit T is turned on, the first voltage may be applied to the anode and the cathode of the plasma generator through the first capacitor C1. The gas between the anode and the cathode of the plasma generator is broken down under an action of the first voltage, to gradually generate the plasma. The resistance of the plasma is small, and a plasma current may be formed between the anode and the cathode of the plasma generator. Since the capacitance of the first capacitor C1 is small and the output voltage is large, the output voltage of the first capacitor C1 decreases rapidly. When the output voltage of the first capacitor C1 decreases from the first voltage to below the output voltage of the second capacitor C2 (such as the second voltage), the second capacitor C2 outputs a voltage to the plasma generator to maintain the second voltage to be outputted to the plasma generator, so as to maintain the plasma to be generated between the anode and the cathode of the plasma generator.

As the second capacitor C2 discharges, its capacitance will gradually decrease, and after a certain period of time, the second capacitor C2 will not be able to maintain the second voltage to be outputted to the plasma generator. After that, the plasma current between the anode and the cathode of the plasma generator gradually disappears. The breakdown current module 101 outputs a pulse current to the plasma generator 20, and a duration of the second voltage is a pulse width of the pulse current. For example, the second capacitor C2 may maintain the second voltage to be outputted to the plasma generator for 30 milliseconds. This duration is related to the capacitance, the discharge performance, the output voltage, and the like of the second capacitor C2, and may be 20ms, 40ms, or other durations, and this duration may even reach 100ms to 200ms, which is not limited in the embodiments of the present disclosure. With the discharge to the plasma generator, heat will be gradually accumulated on the plasma generator, which may cause equipment damage. Therefore, in the embodiment of the present disclosure, the second capacitor C2 may maintain the second voltage to be outputted to the plasma generator for a short time.

In an example, the capacitance of the first capacitor C1 may be 100 microfarads and the capacitance of the second capacitor C2 may be 0.28 farads. The output voltage of the first capacitor C1 may range from 1300V to 1500V, and the output voltage of the second capacitor C2 may range from 200V to 400V. For example, the output voltage of the first capacitor C1 may be 1500V, and the output voltage of the second capacitor C2 may be 400V. The output current of the first capacitor C1 and the output current of the second capacitor C2 may be the same, for example, both are 2000 amps. This value is only an example, and the capacitances, the output voltages, and output currents of the first capacitor C1 and the second capacitor C2 may also be different from the above values, and the respective parameters of the first capacitor C1 and the second capacitor C2 may also be adjusted accordingly in response to different requirements for the plasma current.

In some embodiments, the switching unit T is an insulated-gate bipolar transistor (IGBT), a first end of the switching unit T is a collector, and the second end of the switching unit T is an emitter. A gate of the switching unit T may be connected with a control unit, and this control unit may control the switching unit T to be turned on or turned off. The switching unit T may also be replaced by other power devices capable of supporting larger current transmission.

In the embodiment of the present disclosure, two capacitors are used in the breakdown power supply module 101 to achieve gas breakdown and plasma maintenance. The two capacitors include a high-voltage low-capacitance capacitor and a low-voltage high-capacitance capacitor. Since the implementation technology of a capacitor with such characteristics is relatively mature, the capacitors required in the breakdown power supply module 101 is easy to obtain and control, and the plasma power supply is economical.

Both the first capacitor C1 and the second capacitor C2 in the breakdown power supply module 101 may be connected with a direct current power supply, so that the first capacitor C1 is charged to a first voltage and the second capacitor C2 is charged to a second voltage via the direct current power supply. After the power supply is disconnected, the pressure and the magnetic field in the plasma generator may be adjusted to the required conditions, and then the switching unit T is turned on, so that the breakdown power supply module 101 discharges to the plasma generator.

In some embodiments, continually referring to FIG. 2, the breakdown power supply module 101 may further include: a first anti-reverse diode D1, a second anti-reverse diode D2, a first current-limiting resistor R1, a second current-limiting resistor R2 and a third current-limiting resistor R3. The first anti-reverse diode D1 and the first current-limiting resistor R1 are arranged on a branch of the first capacitor C1, and are connected in series with the first capacitor C1. The second anti-reverse diode D2 and the second current-limiting resistor R2 are arranged on a branch of the second capacitor C2, and are connected in series with the second capacitor C2. The third current-limiting resistor R3 is arranged on the branch where the switching unit T is arranged.

The first anti-reverse diode D1 is configured to prevent the current and the voltage of the first capacitor C1 from reversing, and the second anti-reverse diode D2 is configured to prevent the current and the voltage of the second capacitor C2 from reversing. The first current-limiting resistor R1, the second current-limiting resistor R2 and the third current-limiting resistor R3 are configured to prevent the current in the circuit from being too high when the anode and the cathode of the plasma generator break down the gas, to reduce current oscillation in the circuit. In a case that the gas is broken down, the output voltage of the first capacitor C1 may be mainly consumed by the first current-limiting resistor R1, and the output voltage of the second capacitor C2 may be mainly consumed by the second current-limiting resistor R2.

The above anti-reverse diodes and the current-limiting resistors may be connected in the following manner.

The positive electrode of the first capacitor C1 is connected with an auxiliary node J through the first anti-reverse diode D1 and the first current-limiting resistor R1, and an input end of the first anti-reverse diode D1 is connected with the positive electrode of the first capacitor C1, and an output end of the first anti-reverse diode D1 is connected with the auxiliary node J. In FIG. 2, a connection manner that the input end of the first anti-reverse diode D1 is connected with the positive electrode of the first capacitor C1 via the first current-limiting resistor R1 is taken as an example, that is, the first current-limiting resistor R1 is arranged between the first capacitor C1 and the first anti-reverse diode D1. The positions of the first anti-reverse diode D1 and the first current-limiting resistor R1 may also be interchanged.

The positive electrode of the second capacitor C2 is connected with the auxiliary node J via the second anti-reverse diode D2 and the second current-limiting resistor R2, and an input end of the second anti-reverse diode D2 is connected with the positive electrode of the second capacitor C2, and an output end of the second anti-reverse diode D2 is connected with the auxiliary node J. In FIG. 2, a connection manner that the output end of the second anti-reverse diode D2 is connected with the auxiliary node J through the second current-limiting resistor R2 is taken as an example, that is, the second anti-reverse diode D2 is arranged between the second capacitor C2 and the second current-limiting resistor R2. The second anti-reverse diode D2 and the second current-limiting resistor R2 may also be interchanged.

A first end of the switching unit T is connected with the auxiliary node J, and the second end of the switching unit T is connected with the anode of the plasma generator via the third current-limiting resistor R3. The second end of the switching unit T is connected with a first end of the third current-limiting resistor R3, and a second end of the third current-limiting resistor R3 is connected with the anode of the plasma generator.

A resistance of the first current-limiting resistor R1 may be greater than a resistance of the second current-limiting resistor R2. Each of the resistance of the first current-limiting resistor R1 and the resistance of the second current-limiting resistor R2 may be greater than a resistance of the third current-limiting resistor R3. For example, the resistance of the first current-limiting resistor R1 may be 5 ohms, the resistance of the second current-limiting resistor R2 may be 250 milliohms, and the resistance of the third current-limiting resistor R3 may be 100 milliohms. The above resistances may also be other values, which may be specifically set according to circuit requirements, and are not limited in the embodiments of the present disclosure.

In the embodiment of the present disclosure, some of the first anti-reverse diode D1, the second anti-reverse diode D2, the first current-limiting resistor R1, the second current-limiting resistor R2 and the third current-limiting resistor R3 may not be provided, and a circuit structure of the breakdown power supply module 101 may be adjusted accordingly, and other circuit structures obtained by adjustment will not be additionally illustrated here.

In some embodiments, continually referring to FIG. 2, the breakdown power supply module 101 may further include: a first bypass resistor R4. Two ends of the first bypass resistor R4 may be connected with an anode and a cathode of the plasma generator, respectively. The second end of the switching unit T is further connected with a first end of the first bypass resistor R4, and the negative electrode of the first capacitor C1 is further connected with a second end of the first bypass resistor R4. In a case that the breakdown power supply module 101 includes the third current-limiting resistor R3, the second end of the switching unit T may be connected with a first end of the first bypass resistor R4 via the third current-limiting resistor R3.

The first bypass resistor R4 is configured to prevent the cathode and the anode of the plasma generator from not being broken down to affect the circuit, and the current outputted by the first capacitor C1 and the second capacitor C2 may be transmitted via the first bypass resistor R4 if the cathode and the anode of the plasma generator are not broken down. For example, the first bypass resistor R4 is configured to transmit a current corresponding to a first voltage in a case that the breakdown power supply module 101 outputs the first voltage to the plasma generator and the plasma generator does not generate the plasma. Even if the cathode and anode of the plasma generator cannot break down the gas due to some reasons (for example, the gas pressure and the magnetic field do not meet the requirements or the load of the plasma itself is unstable), the energy in the first capacitor C1 and the second capacitor C2 can be slowly released via the first bypass resistor R4 to ensure reliability of the circuit.

A resistance of the first bypass resistor R4 may be greater than the resistance of the first current-limiting resistor R1, the resistance of the second current-limiting resistor R2, and the resistance of the third current-limiting ancestor R3. For example, the first bypass resistor R4 may have a resistance of 500 ohms. This resistance may also be other values, which may be specifically set according to circuit requirements, and are not limited in the embodiments of the present disclosure.

In some embodiments, continually referring to FIG. 2, the breakdown power supply module 101 may further include: a third capacitor C3 and a third anti-reverse diode D3. The third capacitor C3 may be connected in parallel with the third anti-reverse diode D3 and connected in parallel with the first bypass resistor R4.

The second end of the switching unit T is further connected with a positive electrode of the third capacitor C3, and the negative electrode of the first capacitor C1 is further connected with a negative electrode of the third capacitor C3. The positive electrode of the third capacitor C3 is further connected with an output end of the third anti-reverse diode D3, and the negative electrode of the third capacitor C3 is further connected with an input end of the third anti-reverse diode D3. In a case that the breakdown power supply module 101 includes the third current-limiting resistor R3, the second end of the switching unit T may be connected with the positive electrode of the third capacitor C3 via the third current-limiting resistor R3.

The third capacitor C3 may absorb an abrupt current generated in a case that the plasma generator breaks down the gas to generate the plasma. When the plasma generated between the anode and cathode of the plasma generator forms a plasma current, a load in the circuit will suddenly become smaller, and there may be stray inductance in the circuit to make the current in the circuit suddenly become large. The third capacitor C3 may absorb this suddenly increased current to ensure the stability of the circuit. When the plasma current between the anode and the cathode of the plasma generator is extinguished, a current spike may also occur in the circuit to generate the abrupt current, and the abrupt current at this case may also be absorbed by the third capacitor C3.

The third capacitor C3 may be a high-voltage withstanding capacitor. A capacitance of the third capacitance C3 may be smaller than the capacitance of the first capacitor C1 and the capacitance of the second capacitor C2. For example, the capacitance of the third capacitor C3 may be in an order of microfarads, e.g. the capacitance of the third capacitor C3 is 2.8 microfarads. This capacitance may also be other values, which may be specifically set according to circuit requirements, and are not limited in the embodiments of the present disclosure.

Continually referring to FIG. 2, the lead-out power supply module 102 includes: at least two capacitor modules M connected in series. In these at least two capacitor modules connected in series, the two capacitor modules at the two ends are respectively connected with the housing of the nuclear fusion reaction chamber and the anode of the plasma generator. Each capacitor module M may include: a capacitor C and at least two switches respectively connected with two ends of the capacitor C.

In a case that the breakdown power supply module 101 outputs the first voltage, the two switches which are respectively connected with the two ends of the capacitor C in each capacitor module M are turned on, so that the capacitors C in each capacitor module M are connected in series. If the switching unit T is turned on, the two switches respectively connected with the two ends of the capacitor C may be turned on. In turn, the capacitors C connected in series collectively apply a voltage to the housing of the nuclear fusion reaction chamber and the anode of the plasma generator to form an electric field between the housing and the anode. Under an action of this electric field, a plasma current is formed between the housing and the anode by using the plasma generated by the plasma generator.

In the embodiment of the present disclosure, the difference between a duration of the plasma current between the housing of the nuclear fusion reaction chamber and the anode of the plasma generator and a duration of the plasma current between the cathode and the anode of the plasma generator is small. The duration difference between these two durations may be within 0.5ms, for example, the plasma current between the housing of the nuclear fusion reaction chamber and the anode of the plasma generator may also be maintained for 30ms. In this way, the anode of the plasma generator can be prevented from discharging to the housing of the nuclear fusion reaction chamber to cause ablation of the housing of the nuclear fusion reaction chamber; and a utilization rate of the plasma can be improved, the duration of a nuclear fusion reaction can be prolonged; and an irregular movement of the plasma in the nuclear fusion reactor can be avoided, and an influence on the working process of other components can be avoided.

In the at least two capacitor modules M in the breakdown power supply module 102, the voltage provided by one capacitor module M may be used as a substrate, and the voltages provided by the other capacitor modules M may be used as floating voltages superimposed on the substrate. By providing the multiple capacitor modules M, a current waveform can be controlled more finely, the plasma current led out to the nuclear fusion reaction chamber is ensured to have a small variation amplitude within a duration, and a waveform of the plasma current can be in a flat-top waveform. Based on this plasma current, the stability of a subsequent nuclear fusion reaction can be improved.

In the embodiment of the present disclosure, the lead-out power supply module 102 includes two capacitor modules M, and each capacitor module M includes four switches, and each end of each capacitor C is connected with two switches. As shown in FIG. 2, the capacitor module M may be arranged similar to an H-bridge circuit. Each capacitor module includes a first switch T1, a second switch T2, a third switch T3 and a fourth switch T4. In each capacitor module M, a positive electrode of a capacitor C and a first end of the first switch T1 are connected with a first end of the third switch T3, a negative electrode of the capacitor C and a second end of the second switch T2 are connected with a second end of the fourth switch T4, the second end of the first switch T1 is connected with the first end of the second switch T2, and a second end of the third switch T3 is connected with a first end of the fourth switch T4.

In a case that the breakdown power supply module 101 outputs the first voltage, the second switch T2 and the third switch T3 in each capacitor module M are turned on, and the first switch T1 and the fourth switch T4 are turned off. In this case, the capacitors C in the two capacitor modules M are connected in series to apply a voltage to the housing of the nuclear fusion reaction chamber and the anode of the plasma generator, to form an electric field between the housing and the anode, so as to form the plasma current.

In a case that the second switch T2 and the third switch T3 in each capacitor module M are turned on, a Pulse Width Modulation (PWM) may be used to adjust a turn-on duty ratio of the switches, so as to control a current waveform of a current transmitted in the lead-out power supply module 102. For example, the current waveform may be a flat-topped wave, and a variation value of the plasma current is less than a target threshold, to ensure the basically constant plasma current. An adjustment parameter for the turn-on duty ratio may be set based on a measured current and voltage in the lead-out power supply module 102 (for example, the voltage outputted by the capacitor C). For example, the second switch T2 in each capacitor module M may be kept in the turned-on state, and the turn on-duty ratio of the third switch T3 may be adjusted.

The capacitor C in the capacitor module M may output a current meeting a requirement of the nuclear fusion reaction chamber. The plasma current required in the nuclear fusion reaction chamber is large, for example, the plasma current needs to reach 10 kiloamperes. Each switch in each capacitor module M may be composed of multiple sub-switches to ensure that each switch can support the transmission of 10 kiloamperes of current. The capacitor C in the capacitor module M may be an aluminum electrolytic capacitor. The capacitance of the capacitor C may be small, for example, 0.56 farad. The output voltage of the capacitor C may also be small, for example, the capacitors C in the capacitor modules M may have the same type, and the same capacitance. The capacitors C in different capacitor modules M may also be different, and control parameters of a modulation model may be adjusted accordingly. The capacitor C may be a single capacitor or formed by multiple sub-capacitors connected in parallel.

Each switch in the capacitor module M may be an insulated gate bipolar transistor IGBT, a first end of the switch is a collector, and a second end of the switch is an emitter. A gate of the switch may be connected with a control unit, the control unit may control the switch to be turned on or turned off. The IGBT includes a diode connected in parallel with the transistor. During a discharge process of the capacitor C in the capacitor module M, the first switch T1 and the fourth switch T4 may only function as diodes. In some embodiments, the first switch T1 and the fourth switch T4 may also be replaced with diodes. The switch may also be replaced by other power devices capable of supporting large current transmission.

In some embodiments, the switches in the two capacitor modules M may belong to an integral module, the capacitors C in the two capacitor modules M may belong to an integral module, and the two modules may be connected to obtain the two capacitor modules M connected in series. In this way, a structure of the lead-out power supply module 101 may be simple and may be flexibly adjusted. If the second switch T2 or the third switch T3 in any capacitor module M fails, it is only required to reversely connected the capacitor C with the module to which the switches belong, so that the positive electrode of the capacitor C is connected with the second end of the second switch T2 and the second end of the fourth switch T4 without replacing the whole circuit structure, facilitating circuit maintenance.

In the embodiment of the present disclosure, the lead-out power supply module 102 may also include three or more capacitor modules M, the capacitor module M may also only include three or two switches, and one end of the capacitor C may only be connected with one switch. For example, the capacitor module M may not be provided with the first switch T1 and the fourth switch T4.

In some embodiments, continually referring to FIG. 2, the lead-out power supply module 102 may further include: a second bypass resistor R5. Two ends of the second bypass resistor R5 may be respectively connected with the housing of the nuclear fusion reaction chamber and the anode of the plasma generator. Two capacitor modules M at the two ends of the at least two capacitor modules M connected in series may further respectively connected with the two ends of the second bypass resistor R5.

The second bypass resistor R5 is configured to prevent a failed generation of the plasma current between the housing and the anode from affecting the circuit. When the plasma current is not generated, the current transmitted by the capacitor C in each capacitor module M may be transmitted through the second bypass resistor R5. Even if the plasma current cannot be generated due to some reasons, the energy in the capacitor C can be slowly released via the second bypass resistor R5 to ensure the reliability of the circuit. For example, the second bypass resistor R5 may have a resistance of 30ohms. This resistance may also be other values, which may be specifically set according to circuit requirements, and is not limited in the embodiments of the present disclosure.

In some embodiments, continually referring to FIG. 2, the lead-out power supply module 102 may further include an inductor L, and the capacitor module M is connected with the housing of the nuclear fusion reaction chamber via the inductor L. For example, in the capacitor module M, the second end of the third switch T3 is connected with the first end of the fourth switch T4, and both of the second end of the third switch T3 and the first end of the fourth switch T4 are connected with a first end of the inductor L, and a second end of the inductor L is connected with the housing of the nuclear fusion reaction chamber.

The inductor L may act as a current stabilizer in the lead-out power supply module 102 to reduce a ramp up rate and a ramp down rate of the current and balance instability of a plasma load. When a plasma impedance between the housing of the nuclear fusion reaction chamber and the anode of the plasma generator becomes higher, the inductor L can ensure that a higher voltage is provided for the housing of the nuclear fusion reaction chamber, so as to ensure the stability of the current in a circuit. Even if the plasma current between the anode and the cathode of the plasma generator is quenched, it can also be ensured that the plasma current between the housing of the nuclear fusion reaction chamber and the anode of the plasma generator is not influenced, thereby ensuring safety of the power supply.

A rated current of the inductor L may be high, and a structural strength may be high. The inductance of the inductor L may be small, for example, the inductance of the inductor L may be 50 microhenries. This inductance may also be other values, which may be specifically set according to circuit requirements, and is not limited in the embodiments of the present disclosure.

In some embodiments, continually referring to FIG. 2, the lead-out power supply module 102 may further include: a fourth current-limiting resistor R4. The capacitor module M is connected with the housing of the nuclear fusion reaction chamber via the fourth current-limiting resistor R4 and the inductor L. The fourth current-limiting resistor R4 may be arranged between the capacitor module M and the inductor L, and the capacitor module M is connected with the first end of the inductor L via the fourth current-limiting resistor R4. Alternatively, the inductor L may also be arranged between the capacitor module M and the fourth current-limiting resistor R4.

The fourth current-limiting resistor R4 is configured to prevent the current in the circuit from being too high when the plasma current is generated between the housing of the nuclear fusion reaction chamber and the anode of the plasma generator, to reduce a current oscillation in the circuit. The resistance of the fourth current-limiting resistor R4 may be small, for example, the resistance of the fourth-current limiting resistor R4 may be 50 milliohms. This resistance may also be other values, which may be specifically set according to circuit requirements, and is not limited in the embodiments of the present disclosure.

In some embodiments, continually referring to FIG. 2, the lead-out power supply module 102 may further include: a freewheel diode D4. An input end of the freewheel diode D4 is connected with the anode of the plasma generator, and an output end of the freewheel diode D4 is connected with the housing of the nuclear fusion reaction chamber. The freewheel diode D4 may be arranged after the inductor L, and the second end of the inductor L is further connected with the output end of the freewheel diode D4, and the input end of the freewheel diode D4 is connected with the negative electrode of the capacitor C in the capacitor module M. For example, the input end of the freewheel diode D4 is connected with the second end of the first switch T1 and the first end of the second switch T2, and further connected with the negative electrode of the capacitor C in the capacitor module M via the second switch T2.

This freewheel diode D4 may be configured to freewheel the plasma between the housing of the nuclear fusion reaction chamber and the anode of the plasma generator, and to freewheel stray inductances in a transmission line of the lead-out power supply module 102. In a case that the capacitor C in the capacitor module M stops discharging, the plasma current between the housing of the nuclear fusion reaction chamber and the anode of the plasma generator, as well as the current generated by the stray inductance in the transmission line may further be transmitted via the freewheel diode D4.

In the embodiment of the present disclosure, only FIG. 2 is taken as an example to illustrate a case where the plasma power supply 10 includes all the above components. The components in the above different embodiments may also be combined in different ways to obtain different structures of the plasma power supply 10, which are not shown here.

In the plasma power supply 10 provided in the embodiment of the present disclosure, the breakdown power supply module 101 is responsible for providing a breakdown voltage (that is, the above first voltage) and a pulse current to the plasma generator. If the breakdown voltage reaches 1500 V, the current value of the pulse current is 2000 amperes, and the duration may reach 30ms. This breakdown voltage is provided by the first capacitor C1. In a case that the breakdown voltage is applied to the cathode and the anode of the plasma generator, the gas in the plasma generator may be broken down to generate the plasma. After that, the output voltage of the breakdown power supply module 101 may be quickly reduced to the second voltage (for example, 400V) and maintained at the second voltage, and the pulse current of 2000 amperes is continuously outputted. This maintained second voltage and a subsequent continuously outputted current are provided by the second capacitor C2. In this way, the breakdown power supply module 101 and the plasma generated by the plasma generator may form a plasma current loop, and the plasma current may be maintained. The lead-out power supply module 102 is responsible for leading out the plasma current from the plasma generator into the nuclear fusion reaction chamber. The lead-out power supply module 102 may output a current of 10 kiloamperes, and a duration may reach 30 milliseconds. In a case that the breakdown power supply module 101 drives the plasma generator 20 to generate plasma, the housing of the nuclear fusion reaction chamber, and the anode and the cathode of the plasma generator may form a plasma current loop.

In the embodiment of the present disclosure, each capacitor in the plasma power supply 10 may be charged to a target capacitance first. For example, the first capacitor C1 in the breakdown power supply module 101 may be charged to 1500V, the second capacitor C2 may be charged to 400V, and the capacitor C in the lead-out power supply module 102 may be charged up to 300V. After that, conditions such as air pressure and magnetic field in the plasma generator and the nuclear fusion reaction chamber may be adjusted to appropriate parameters, then the switching unit T is turned on. In this case, the breakdown power supply module 101 uses the first capacitor C1 to apply a breakdown voltage on the cathode and the anode of the plasma generator, and the current outputted by the first capacitor C1 and the second capacitor C2 may be transmitted via the first bypass resistor R4. Under the action of the breakdown voltage, the gas between the cathode and the anode of the plasma generator is broken down to gradually generate the plasma, and the current outputted by the first capacitor C1 and the second capacitor C2 may be transmitted via the plasma. Since the impedance of the plasma is small when used as a load, the first bypass resistor R4 is considered as being short-circuited. After that, the voltage of the first capacitor C1 rapidly decreases below the second voltage (for example, 400 V), and the second capacitor C2 maintains to discharge to the plasma generator, and the current is maintained for about 30 milliseconds.

When the switching unit T is triggered to be turned on, the second switch T2 and the third switch T3 in each capacitor module M of the lead-out power supply module 102 may be simultaneously triggered to be turned on. In this case, the capacitor C, the fourth current-limiting resistor R6, the inductor L and the second bypass resistor R5 in the capacitor module M form a current loop. Moreover, the lead-out power supply module 102 forms an electric field between the housing of the nuclear fusion reaction chamber and the anode of the plasma generator. In this process, the turn-on duty ratios of the second switch T2 and the third switch T3 may be controlled based on the output voltage of the capacitor C, to ensure a constant power supply in the circuit. In a case that the gas between the cathode and the anode of the plasma generator is broken down to gradually generate the plasma, the plasma may be diffused between the housing of the nuclear fusion reaction chamber and the anode of the plasma generator and gradually form the plasma current under the action of an electric field, so that the plasma current is formed in the nuclear fusion reaction chamber. The plasma current may also last for 30 milliseconds. In this way, a plasma current loop is formed between the housing of the nuclear fusion reaction chamber and the anode and the cathode of the plasma generator.

If no breakdown is achieved between the cathode and the anode of the plasma generator in the above process, the breakdown power supply module 101 may release the capacitor voltage via the first bypass resistor R4, and the lead-out power supply module 102 may release the capacitor voltage via the second bypass resistor R5.

In the plasma power supply provided in the embodiment of the present disclosure, the breakdown power supply module may output a high breakdown voltage, to meet the requirement of the plasma generator on stable breakdown. In a case that the plasma is generated, the output voltage of the breakdown power supply module may be automatically maintained at a low voltage to meet the requirement of stably maintaining the plasma. The lead-out power supply module may lead out the plasma current with a large current value to meet the requirement of driving the plasma with a large current. The lead-out power supply module may adopt a feedback control technology to adjust a waveform of the lead-out plasma current by controlling the turn-on duty ratio of the switch, so that the waveform of the plasma current can be a flat-top waveform, ensuring the stability of the plasma current. In addition, the lead-out power supply module may prevent, by using the inductor, the influence on the plasma current in the nuclear fusion reaction chamber when the plasma current at the plasma generator is quenched, and this power supply is highly secure.

To sum up, the plasma power supply according to the embodiment of the present disclosure includes a breakdown power supply module and a lead-out power supply module, where the breakdown power supply module may be used to drive a plasma generator to generate plasma, and the plasma is maintained at a stage that an output voltage of the breakdown power supply module is maintained at a second voltage. The lead-out power supply module may form an electric field between the plasma generator and a housing of a nuclear fusion reaction chamber, and form a plasma current between the housing and the plasma generator based on the plasma generated by the plasma generator and the electric field, so that the plasma current is led out into the nuclear fusion reaction chamber. Therefore, the plasma current can be obtained without applying an additional magnetic field to control the plasma generated by the plasma generator, thereby simplifying a formation process of the plasma current.

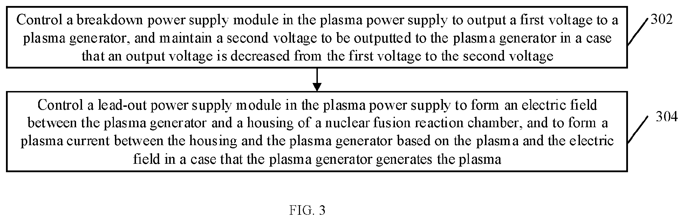

FIG. 3 is a flow chart of a method for controlling a plasma power supply according to an embodiment of the present disclosure. The method is applied to the above plasma power supply 10. For example, the plasma power supply 10 may be connected with a control unit with which the control method may be performed to control the plasma power supply 10. As shown in FIG. 3, the method may include the following steps 302 and 304.

In step 302, a breakdown power supply module in the plasma power supply is controlled to provide a first voltage to a plasma generator, and a second voltage is maintained to be outputted to the plasma generator in a case that an output voltage is decreased from the first voltage to the second voltage.

The control unit may control the switching unit in the breakdown power supply module to be turned on, to control the breakdown power supply module to output the first voltage to the plasma generator. The plasma may be generated between the anode and the cathode of the plasma under an action of the first voltage. After that, the output voltage of the breakdown power supply module may automatically decreases, and when the output voltage decreases to the second voltage, the second voltage may be maintained to be outputted. This first voltage and the second voltage may be provided by two capacitors in the breakdown power supply module, respectively.

In step 304, the lead-out power supply module in the plasma power supply is controlled to form an electric field between the plasma generator and a housing of a nuclear fusion reaction chamber, and a plasma current is generated between the housing and the plasma generator based on the plasma and the electric field in a case that the plasma generator generates the plasma.

For example, at least when the control unit controls the breakdown power supply module to output the first voltage to the plasma generator, the control unit may control a capacitor in the lead-out power supply module to output a current so as to form the electric field between the plasma generator and the housing of the nuclear fusion reaction chamber. In a case that the plasma is generated, a plasma current may be formed between the housing of the nuclear fusion reaction chamber and the anode of the plasma generator under an action of the electric field.

Continually referring to FIG. 2, the control unit controls the two switches (such as the second switch T2 and the third switch T3) which are respectively connected with the two ends of the capacitor C in each capacitor module M to be turned on, so that the capacitor C in each capacitor module M outputs a voltage to the housing of the nuclear fusion reaction chamber, so as to form the electric field between the plasma generator and the housing.

In a process of controlling the two switches respectively connected with the two ends of the capacitor C in each capacitor module M to be turned on, a turn-on duty ratio of the switch in each capacitor module M is adjusted, so that a variation value of the plasma current is less than a target threshold.

For the control method shown in FIG. 3, reference may be made to the above description of the plasma power supply, and a detailed description thereof will not be provided here.

In summary, with the method for controlling a plasma power supply provided in the embodiments of the present disclosure, the breakdown power supply module in the plasma power supply may be controlled to output the first voltage to the plasma generator, so that the plasma generator generates the plasma, and the plasma is maintained in a case that the output voltage of the breakdown power supply module is maintained at the second voltage. The lead-out power supply module is controlled to form the electric field between the plasma generator and the housing of a nuclear fusion reaction chamber, and form the plasma current between the housing and the plasma generator based on the plasma generated by the plasma generator and the electric field, so that the plasma current is led out into the nuclear fusion reaction chamber. In this way, the plasma current can be obtained without applying an additional magnetic field to control the plasma generated by the plasma generator, thereby simplifying the formation process of the plasma current.

The above describes specific embodiments of the present disclosure. Other embodiments are within the scope of the claims. In some cases, the acts or steps recited in the claims may be performed in a different order than those in the embodiments and still achieve desirable results. In addition, the processes depicted in the drawings do not necessarily require the particular order shown or the sequential order to achieve desirable results. Multitasking and parallel processing are also possible or may be advantageous in some embodiments.

Those skilled in the art should also understand that the embodiments described in the specification are all preferred embodiments, and the acts and modules involved are not necessarily required for the present disclosure. In the above embodiments, the description of each embodiment has its own emphasis, and for a part not described in detail in a certain embodiment, reference may be made to the relevant description of other embodiments.

The preferred embodiments disclosed above are only intended to assist in elucidating the present disclosure. The optional embodiments do not provide a detailed description of all the details, nor does it limit the scope of the present disclosure to the specific embodiments described. Obviously, many modifications and variations are possible in light of the teachings of the present disclosure. These embodiments are chosen and described in detail in order to better explain the principles of the present disclosure and the practical application, so that those skilled in the art may better understand and use the present disclosure.

## Claims

1. A plasma power supply, comprising:
a breakdown power supply module, configured to provide a first voltage to a plasma generator, wherein the plasma generator generates plasma under an action of the first voltage; and maintain, in a case that an output voltage is decreased from the first voltage to the second voltage, a second voltage to be outputted to the plasma generator; and
a lead-out power supply module, configured to form an electric field between the plasma generator and a housing of a nuclear fusion reaction chamber, and form, in a case that the plasma generator generates the plasma, a plasma current between the housing and the plasma generator based on the plasma and the electric field.

2. The plasma power supply according to claim 1, wherein the breakdown power supply module comprises: a first capacitor, a second capacitor, and a switching unit, and a capacitance of the first capacitor is less than a capacitance of the second capacitor;
a positive electrode of the first capacitor is connected with a positive electrode of the second capacitor, a negative electrode of the first capacitor is connected with a negative electrode of the second capacitor, the positive electrode of the first capacitor is further connected with a first end of the switching unit, a second end of the switching unit is connected with an anode of the plasma generator, and the negative electrode of the first capacitor is further connected with a cathode of the plasma generator; and
the first capacitor is configured to provide the first voltage to the plasma generator in a case that the switching unit is turned on; and the second capacitor is configured to maintain, in a case that the output voltage is decreased from the first voltage to the second voltage, the second voltage to be outputted to the plasma generator.

3. The plasma power supply according to claim 2, wherein the breakdown power supply module further comprises: a first anti-reverse diode, a second anti-reverse diode, a first current-limiting resistor, a second current-limiting resistor and a third current-limiting resistor, wherein a resistance of the first current-limiting resistor is greater than a resistance of the second current-limiting resistor;
the positive electrode of the first capacitor is connected with an auxiliary node through the first anti-reverse diode and the first current-limiting resistor, and an input end of the first anti-reverse diode is connected with the positive electrode of the first capacitor, and an output end of the first anti-reverse diode is connected with the auxiliary node;
the positive electrode of the second capacitor is connected with the auxiliary node through the second anti-reverse diode and the second current-limiting resistor, and an input end of the second anti-reverse diode is connected with the positive electrode of the second capacitor, and an output end of the second anti-reverse diode is connected with the auxiliary node; and
the first end of the switching unit is connected with the auxiliary node, and the second end of the switching unit is connected with the anode of the plasma generator through the third current-limiting resistor.

4. The plasma power supply according to claim 2 or 3, wherein the breakdown power supply module further comprises: a first bypass resistor;
the second end of the switching unit is further connected with a first end of the first bypass resistor, and the negative electrode of the first capacitor is further connected with a second end of the first bypass resistor; and
the first bypass resistor is configured to: transmit a current corresponding to the first voltage in a case that the breakdown power supply module provides the first voltage to the plasma generator and the plasma generator does not generate the plasma.

5. The plasma power supply according to claim 2 or 3, wherein the breakdown power supply module further comprises: a third capacitor and a third anti-reverse diode;
the second end of the switching unit is further connected with a positive electrode of the third capacitor, and the negative electrode of the first capacitor is further connected with a negative electrode of the third capacitor; the positive electrode of the third capacitor is further connected with an output end of the third anti-reverse diode, and the negative electrode of the third capacitor is further connected with an input end of the third anti-reverse diode; and
the third capacitor is configured to absorb an abrupt current generated in a case that the plasma generator generates the plasma.

6. The plasma power supply according to claim 1, wherein the lead-out power supply module comprises: at least two capacitor modules connected in series, and two capacitor modules at two ends of the at least two connected capacitor modules connected in series are respectively connected with the housing of the nuclear fusion reaction chamber and the anode of the plasma generator; and
each of the at least two capacitor modules comprises: a capacitor and at least two switches respectively connected with two ends of the capacitor; in a case that the breakdown power supply module outputs a first voltage, two switches respectively connected with the two ends of the capacitor in each capacitor module are turned on, and capacitors in the at least two capacitor modules output a voltage to form an electric field between the housing and the anode.

7. The plasma power supply according to claim 6, wherein each of the at least two capacitor modules comprises: a first switch, a second switch, a third switch and a fourth switch;
in each of the at least two capacitor modules, a positive electrode of a capacitor and a first end of the first switch are connected with a first end of the third switch, a negative electrode of the capacitor and a second end of the second switch are connected with a second end of the fourth switch, a second end of the first switch is connected with a first end of the second switch, and a second end of the third switch is connected with a first end of the fourth switch; and
in a case that the breakdown power supply module outputs a first voltage, the second switch and the third switch in each capacitor module are turned on, and the first switch and the fourth switch are turned off.

8. The plasma power supply according to claim 7, wherein each switch in each of the at least two capacitor modules is an insulated gate bipolar transistor (IGBT), a first end of the switch is a collector, and a second end of the switch is an emitter.

9. The plasma power supply according to any one of claims 6 to 8, wherein the lead-out power supply module further comprises: a second bypass resistor;
the two capacitor modules at the two ends of the at least two capacitor modules connected in series are further respectively connected with two ends of the second bypass resistor; and
the second bypass resistor is configured to: transmit a current outputted by capacitors in the at least two capacitor modules in a case that an electric field is formed between the housing and the anode and a plasma current is not generated.

10. The plasma power supply according to any one of claims 6 to 8, wherein the lead-out power supply module further comprises: an inductor, a fourth current-limiting resistor, and a freewheel diode;
the at least two capacitor modules are connected with the housing of the nuclear fusion reaction chamber through the inductor and the fourth current-limiting resistor; the at least two capacitor modules are connected with a first end of the inductor, and a second end of the inductor is connected with the housing of the nuclear fusion reaction chamber; and
the second end of the inductor is further connected with an output end of the freewheel diode, and an input end of the freewheel diode is connected with the negative electrodes of capacitors in the at least two capacitor modules.

11. A method of controlling a plasma power supply, applied to the plasma power supply according to any one of claims 1-10, the method comprising:
controlling a breakdown power supply module in the plasma power supply to provide a first voltage to a plasma generator, and maintaining a second voltage to be outputted to the plasma generator in a case that an output voltage is decreased from the first voltage to the second voltage; and
controlling a lead-out power supply module in the plasma power supply to form an electric field between the plasma generator and a housing of a nuclear fusion reaction chamber, and to form, in a case that the plasma generator generates the plasma, a plasma current between the housing and the plasma generator based on the plasma and the electric field.

12. The method according to claim 11, wherein the lead-out power supply module comprises at least two capacitor modules connected in series, and each of the at least two capacitor modules comprises: a capacitor and at least two switches respectively connected with two ends of the capacitor; and
the controlling a lead-out power supply module in the plasma power supply to form an electric field between the plasma generator and the housing of a nuclear fusion reaction chamber comprising:
controlling the two switches respectively connected with two ends of the capacitor in each capacitor module to be turned on, to output a voltage to the housing of the nuclear fusion reaction chamber by the capacitor in each of the at least two capacitor modules to form the electric field between the plasma generator and the housing.

13. The method according to claim 12, further comprising:
in a process of controlling the two switches respectively connected with the two ends of the capacitor in each capacitor module to be turned on, adjusting a turn-on duty ratio of each of the switches in each capacitor module, to control a variation value of the plasma current to be less than a target threshold.

14. A fusion reaction system, comprising: a nuclear fusion reaction apparatus, a plasma generator and the plasma power supply according to any one of claims 1 to 10, wherein
in the plasma power supply, the positive electrode of the breakdown power supply module and the negative electrode of the lead-out power supply module are both connected with the cathode of the plasma generator, and the negative electrode of the breakdown power supply module is connected with the cathode of the plasma generator, and the negative electrode of the lead-out power supply module is connected with the housing of the nuclear fusion reaction chamber in the nuclear fusion reaction apparatus.
